(19) Europäisches Patentamt
European Patent Office
Office européen des brevets

(11) EP 4 738 709 A1

(12) EUROPEAN PATENT APPLICATION

(43) Date of publication:
06.05.2026 Bulletin 2026/19

(21) Application number: 25212163.7

(22) Date of filing: 29.10.2025

(51) International Patent Classification (IPC):
H03L 7/08 (2006.01)     H03L 7/099 (2006.01)
H03L 7/18 (2006.01)

(52) Cooperative Patent Classification (CPC):
H03L 7/0802; H03L 7/099; H03L 7/18

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 30.10.2024 CN 202411534796

(71) Applicant: Amlogic (Shanghai) Co., Ltd.
Shanghai 201315 (CN)

(72) Inventors:
• ZOU, Weihua
Shanghai (CN)
• ZHANG, Yaozhong
Shanghai (CN)

(74) Representative: Piotrowicz, Pawel Jan Andrzej et al
Venner Shipley LLP
406 Cambridge Science Park
Milton Road
Cambridge CB4 0WW (GB)

(54) **PHASE-LOCKED LOOP CIRCUIT, PHASE-LOCKING METHOD, AND FREQUENCY SYNTHESIZER**

(57)     A phase-locked loop circuit, a phase-locking method, and a frequency synthesizer are provided. The phase-locked loop circuit employs phase-rolling clock signal generator component to perform integer frequency division on multiple oscillation clock signals with uniformly varying phases to obtain multiple feedback clock signals with uniformly varying phases; and according to a preset clock cycle, select feedback clock signals with corresponding phase sequences from the multiple feedback clock signals with uniformly varying phases for concatenation, thereby generating the phase-rolling clock signal. This architecture enables fractional-N frequency division phase-locked loop operation. Compared with conventional fractional-N frequency division phase-locked loop implementations using sigma-delta modulator (SDM) circuits, the proposed solution reduces circuit area and power consumption while improving phase-locked loop performance.

FIG. 1

EP 4 738 709 A1

**Description**

CROSS-REFERENCE TO RELATED APPLICATIONS

This application claims priority to Chinese Patent Application No. 202411534796.9, filed on Oct.30, 2024, the entire disclosure of which is incorporated herein by reference.

**TECHNICAL FIELD**

Embodiments of the present disclosure relate to the field of circuit technology, and in particular to a phase-locked loop circuit, a phase-locking method, and a frequency synthesizer.

**BACKGROUND**

In the field of wireless communication, frequency synthesizers based on phase-locked loop (PLL) structures are widely used to generate oscillation signals. Among them, the fractional-N frequency division phase-locked loop (PLL) circuit are applied in many clocks due to their flexible frequency planning.

The digital Sigma-Delta Modulator (SDM) is one of the main components of the fractional-N frequency division phase-locked loop (PLL) circuit. The SDM circuit provides flexibility to the PLL with fractional multiplication factors by jittering the division value of the PLL feedback divider, and has the advantage of noise shaping.

However, the SDM circuit has issues with large circuit area occupation and with high power consumption, which impact the area and power consumption of the fractional-N frequency division PLL circuits.

**SUMMARY**

A problem resolved by some embodiments of the present disclosure is to provide a phase-locked loop circuit, a phase-locking method, and a frequency synthesizer, which achieve a fractional-N phase-locked loop while saving the area and power consumption of the phase-locked loop circuit.

To resolve the above problem, some embodiments of the present disclosure provide a phase-locked loop circuit, including: a phase detection component, configured to receive an external reference clock signal and a phase-rolling clock signal; when the phase of the phase-rolling clock signal leads the external reference clock signal, the phase detection component generates a falling control signal; and when the phase of the phase-rolling clock signal lags the external reference clock signal, the phase detection component generates a rising control signal; a loop filter component, configured to decrease a voltage value of the control voltage signal when receiving the falling control signal; and to increase the voltage value of the control voltage signal when receiving the rising control signal; a voltage-controlled oscillator component, configured to generate a plurality of oscillation clock signals with uniformly varying phases based on the voltage value of the control voltage signal; and a phase-rolling clock signal generator component, configured to perform integer frequency division on the multiple oscillation clock signals with uniformly varying phases, thereby obtaining multiple feedback clock signals with uniformly varying phases; sort the multiple feedback clock signals with uniformly varying phases according to their phase order, thereby determining their phase sequence; and according to a preset clock cycle, select feedback clock signals with corresponding phase sequences from the multiple feedback clock signals with uniformly varying phases for concatenation, thereby generating the phase-rolling clock signal.

Optionally, a target frequency of the oscillation clock signal satisfies: $f_{VCO\_CLK} = f_{REF\_CLK} * (M + \dfrac{X}{N})$;

wherein, $f_{VCO\_CLK}$ represents the target frequency of the oscillation clock signal, $F_{REF\_CLK}$ represents the frequency of the external reference clock signal, M represents the integer frequency division coefficient related to the target frequency of the oscillation clock signal, X represents the numerator of the fractional division coefficient related to the target frequency of the oscillation clock signal, and X is an integer greater than zero and less than or equal to (N-1), N represents the number of multiple feedback clock signals with uniformly varying phases.

Optionally, a phase-rolling clock signal generator component includes: a frequency division processing component, configured to receive a corresponding integer frequency division coefficient and N phase-uniformly varying oscillation clock signals; and to perform frequency division processing on each of the N oscillation clock signals using the integer frequency division coefficient, thereby obtaining N feedback clock signals with uniformly distributed phases; A phase alignment component, configured to sort N feedback clock signals with uniformly distributed phases according to their phase order, thereby determining phase ordinal positions of the N feedback clock signals; and to perform a NOR operation on the N feedback clock signals to generate a phase-rolling control signal; A logic control component, configured to generate a phase selection control signal according to the phase-rolling control signal, and a preset correspondence between a clock cycle of the phase-rolling clock signal and phase ordinal positions of the N phase-uniformly varying feedback clock signals; and also configured to generate a corresponding integer frequency division coefficient based on a preset condition satisfied by the clock cycle of the phase-rolling clock signal and the phase-rolling control signal; And a phase-rolling component, configured to receive the phase-rolling control signal and N phase-uniformly varying feedback clock signals; and at each clock cycle of the phase-rolling clock signal, select and concatenate feedback clock signals with corresponding phase ordinal positions from the N phase-uniformly varying feedback clock signals according to the phase selection control signal, thereby generating the phase-rolling clock signal.

Optionally, the frequency division processing component includes N frequency dividers corresponding one-to-one to the N phase-uniformly varying oscillation clock signals; the frequency dividers, configured to receive a corresponding integer frequency division coefficient and a corresponding one of N phase-uniformly varying oscillation clock signals; and perform frequency division processing on the corresponding oscillation clock signal using the integer frequency division coefficient, thereby obtaining a corresponding feedback clock signal.

Optionally, the phase alignment component includes: a sampling processing sub-component, configured to use a feedback clock signal from a frequency divider at ordinal position 0 to sample and process the feedback clock signals from the frequency dividers at ordinal positions 1 to (N-1), thereby obtaining the corresponding sampled signals; An ordering processing sub-component, configured to determine phase ordinal positions of the N phase-uniformly varying feedback clock signals based on the sampled signals; A logic operation sub-component, configured to perform a NOR logic operation on the N phase-uniformly varying feedback clock signals, thereby obtaining the phase-rolling control signal.

Optionally, the ordering processing sub-component is configured to determine phase ordinal positions of the N phase-uniformly varying feedback clock signals based on the sampled signals using the following equation:

$$CLK\_PHASE < p > = \begin{cases} FB\_CLK < p+Y > & p+Y \leq N-1 \\ FB\_CLK < p+Y-N > & p+Y > N-1 \end{cases} \quad ; \text{ wherein, } CLK\_PHASE < p >$$

represents the feedback clock signal whose phase order is $p$ when the N phase-uniformly-varying feedback clock signals are sorted in ascending order of phase, $FB\_CLK < p + Y >$ represents the feedback clock signal from the frequency divider at ordinal position $(p + Y)$, $FB\_CLK < p+Y-N >$ represents the feedback clock signal from the frequency divider at ordinal position $(p + Y - N)$, $Y$ represents the number of the second sampled value in the sampled signals, and $Y$ is an integer greater than or equal to 0 and less than or equal to $(N-1)$.

Optionally, the number of the second sampled value is 1.

Optionally, the logic control component includes: a first control sub-component, configured to generate a phase selection control signal according to the phase-rolling control signal, and a preset correspondence between the clock cycles of the phase-rolling clock signal and the phase ordinal positions of the N phase-uniformly varying feedback clock signals; A second control sub-component, configured to generate corresponding modulation values based on a preset condition satisfied by the clock cycle of the phase-rolling clock signal and the phase-rolling control signal; And an adder operation sub-component, configured to calculate the sum of the corresponding modulation value and the integer division coefficient related to the target frequency of the oscillation clock signal, thereby obtaining the corresponding integer frequency division coefficient.

Optionally, the first control sub-component, configured to obtain the phase order of the feedback clock signals output by the phase-rolling component in each clock cycle of the phase-rolling clock signal, based on the preset correspondence between the clock cycles of the phase-rolling clock signal and the phase order of the N phase-uniformly varying feedback clock signals; and output the phase order of the corresponding feedback clock signal as the phase selection control signal during the preset clock cycle when the phase-rolling control signal has a first logic level; wherein a preset correspondence between the clock cycles of the phase-rolling clock signal and the phase order of the N phase-uniformly varying feedback clock signals satisfies: $k = \begin{cases} l*X & 0 \leq l*X < N \\ l*X - j_l*N & l*X \geq N \end{cases} \quad ; \text{ and}$

$$j_l = \begin{cases} 0 & l=0 \\ j_{l-1} & 0 < l*X < j_{l-1}*N \\ j_{l-1}+1 & l*X \geq j_{l-1}*N \end{cases} \quad ; \text{ wherein, } k \text{ represents the phase order of the feedback clock signal output}$$

by the phase-rolling component during the $l$-th clock cycle of the phase-rolling clock signal, $j_l$ represents the carry count value of the integer frequency division coefficient related to the target frequency of the oscillation clock signal during the $l$-th clock cycle of the phase-rolling clock signal, $j_{l-1}$ represents the carry count value of the integer frequency division coefficient *M* related to the target frequency of the oscillation clock signal during the (*l*-1) -th clock cycle of the phase-rolling clock signal.

Optionally, the second control sub-component, configured to generate a first modulation value when the phase-rolling control signal is at a first logic level and the clock cycle of the phase-rolling clock signal satisfies preset condition $0 \leq l * X < N$; and to generate a second modulation value when the phase-rolling control signal is at a first logic level and the clock cycle of the phase-rolling clock signal satisfies preset condition $l * X - j_{l-1} * N \geq N$; the adder operation sub-component, configured to calculate a sum of the integer frequency division coefficient *M* related to the target frequency of the oscillator clock signal and the first modulation value as a corresponding integer frequency division coefficient, upon receiving the first modulation value; and to calculate a sum of the integer frequency division coefficient *M* related to the target frequency of the oscillator clock signal and the second modulation value as a corresponding integer frequency division coefficient, upon receiving the second modulation value.

Optionally, the first modulation value is 0, and the second modulation value is 1.

Optionally, the first logic level is defined as a low level.

Correspondingly, some embodiments of the present disclosure further provide a phase-locking method, comprising: using a phase detection component to receive an external reference clock signal and a phase-rolling clock signal; when the phase of the phase-rolling clock signal leads the external reference clock signal, the phase detection component generates a falling control signal; and when the phase of the phase-rolling clock signal lags the external reference clock signal, the phase detection component generates a rising control signal; using a loop filter component to decrease a voltage value of the control voltage signal when receiving the falling control signal; and to increase the voltage value of the control voltage signal when receiving the rising control signal; using a voltage-controlled oscillator component to generate a plurality of oscillation clock signals with uniformly varying phases based on the voltage value of the control voltage signal; and using a phase-rolling clock signal generator component to perform integer frequency division on the multiple oscillation clock signals with uniformly varying phases, thereby obtaining multiple feedback clock signals with uniformly varying phases; to sort the multiple feedback clock signals with uniformly varying phases according to their phase order, thereby determining their phase sequence; and according to a preset clock cycle, select feedback clock signals with corresponding phase sequences from the multiple feedback clock signals with uniformly varying phases for concatenation, thereby generating the phase-rolling clock signal.

Correspondingly, some embodiments of the present disclosure further provides a frequency synthesizer, including a phase-locked loop circuit as described in any one of the above aspects.

Compared with the prior art, the technical solution of the embodiments of the present disclosure has the following advantages.

The phase-locked loop circuit provided by some embodiments of the present disclosure includes: a phase detection component configured to receive an external reference clock signal and a phase-rolling clock signal; when the phase of the phase-rolling clock signal leads the external reference clock signal, the phase detection component generates a falling control signal; and when the phase of the phase-rolling clock signal lags the external reference clock signal, the phase detection component generates a rising control signal; a loop filter component configured to decrease a voltage value of the control voltage signal when receiving the falling control signal; and to increase the voltage value of the control voltage signal when receiving the rising control signal; a voltage-controlled oscillator component configured to generate a plurality of oscillation clock signals with uniformly varying phases based on the voltage value of the control voltage signal; and a phase-rolling clock signal generator component, configured to perform integer frequency division on the multiple oscillation clock signals with uniformly varying phases, thereby obtaining multiple feedback clock signals with uniformly varying phases; sort the multiple feedback clock signals with uniformly varying phases according to their phase order, thereby determining their phase sequence; and according to a preset clock cycle, select feedback clock signals with corresponding phase sequences from the multiple feedback clock signals with uniformly varying phases for concatenation, thereby generating the phase-rolling clock signal.

The phase-locking method provided by some embodiments of the present disclosure, the phase-rolling clock signal generator component is used to perform integer frequency division on multiple oscillation clock signals with uniformly varying phases to obtain multiple feedback clock signals with uniformly varying phases; and according to a preset clock cycle, select feedback clock signals with corresponding phase sequences from the multiple feedback clock signals with uniformly varying phases for concatenation, thereby generating the phase-rolling clock signal. This architecture enables fractional-N frequency division phase-locked loop operation. Compared with conventional fractional-N division phase-locked loop implementations using SDM circuits, the proposed solution reduces circuit area and power consumption while improving phase-locked loop performance.

**BRIEF DESCRIPTION OF THE DRAWINGS**

FIG. 1 is a schematic diagram of an embodiment of a phase-locked loop circuit according to the present disclosure;

FIG. 2 is a schematic diagram of an embodiment of a phase-rolling clock signal generator component according to the present disclosure;

FIG. 3 is a schematic diagram of an embodiment of a frequency division processing component according to the present disclosure;

FIG. 4 is a schematic diagram of an embodiment of a phase alignment component according to the present disclosure;

FIG. 5 is a schematic diagram of an embodiment of a logic control component according to the present disclosure;

FIG. 6 is a schematic diagram of relevant signals when the target frequency of the oscillation clock signal output by the phase-locked loop circuit in the present disclosure is at 5 GHz;

FIG. 7 is a schematic diagram of relevant signals when the target frequency of the oscillation clock signal output by the phase-locked loop circuit in the present disclosure is at 4 GHz;

FIG. 8 is a flowchart of an embodiment of a phase-locking method according to the present disclosure.

## DETAILED DESCRIPTION

As known from the background art, the current fractional-N frequency division phase-locked loop has the problems of large circuit area occupation and high-power consumption.

To resolve the above technical problem, the phase-locked loop circuit provided by the embodiments of the present disclosure includes: a phase detection component, configured to receive an external reference clock signal and a phase-rolling clock signal; when the phase of the phase-rolling clock signal leads the external reference clock signal, the phase detection component generates a falling control signal; and when the phase of the phase-rolling clock signal lags the external reference clock signal, the phase detection component generates a rising control signal; a loop filter component, configured to decrease a voltage value of the control voltage signal when receiving the falling control signal; and to increase the voltage value of the control voltage signal when receiving the rising control signal; a voltage-controlled oscillator component, configured to generate a plurality of oscillation clock signals with uniformly varying phases based on the voltage value of the control voltage signal; and a phase-rolling clock signal generator component, configured to perform integer frequency division on the multiple oscillation clock signals with uniformly varying phases, thereby obtaining multiple feedback clock signals with uniformly varying phases; sort the multiple feedback clock signals with uniformly varying phases according to their phase order, thereby determining their phase sequence; and according to a preset clock cycle, select feedback clock signals with corresponding phase sequences from the multiple feedback clock signals with uniformly varying phases for concatenation, thereby generating the phase-rolling clock signal.

In the phase-locked loop circuit provided by the embodiments of the present disclosure, the phase-rolling clock signal generator component is used to perform integer frequency division on multiple oscillation clock signals with uniformly varying phases to obtain multiple feedback clock signals with uniformly varying phases; and according to a preset clock cycle, select feedback clock signals with corresponding phase sequences from the multiple feedback clock signals with uniformly varying phases for concatenation, thereby generating the phase-rolling clock signal. This architecture enables fractional-N frequency division phase-locked loop operation. Compared with conventional fractional-N division phase-locked loop implementations using SDM circuits, the proposed solution reduces circuit area and power consumption while improving phase-locked loop performance.

In order to make the foregoing objectives, features, and advantages of the embodiments of the present disclosure more apparent and easier to understand, specific embodiments of the present disclosure are described in detail below with reference to the accompanying drawings.

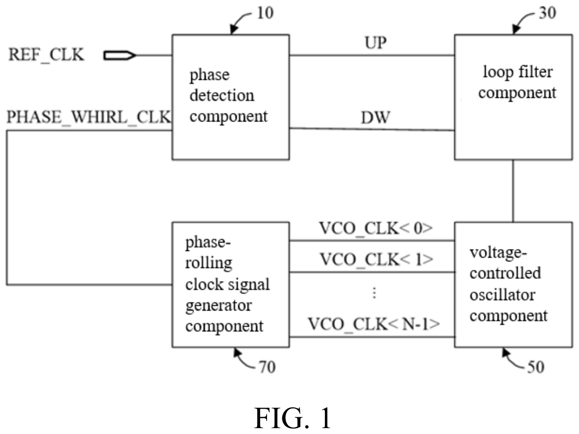

FIG. 1 is a schematic diagram of an embodiment of a phase-locked loop circuit according to the present disclosure. Referring to FIG. 1, a phase-locked loop circuit is disclosed, which includes a phase detection component 10, a loop filter component 30, a voltage-controlled oscillator component 50, and a phase-rolling clock signal generator component 70. The phase detection component 10 is coupled to both the loop filter component 30 and the phase-rolling clock signal generator component 70, and the loop filter component 30 is also coupled to the voltage-controlled oscillator component 50.

In some embodiments, the phase detection component 10 has a reference signal input terminal, a feedback signal input terminal, a falling control signal output terminal, and a rising control signal output terminal. The reference signal input terminal of the phase detection component 10 is used to receive the external reference clock signal REF_CLK, and the feedback signal input terminal of the phase detection component 10 is used to receive the phase-rolling clock signal PHASE_WHIRL_CLK. The falling control signal output terminal of the phase detection component 10 is coupled to the loop filter component 30, and is used to output the falling control signal DW. The rising control signal output terminal of the phase detection component 10 is also coupled to the loop filter component 30, and is used to output the rising control signal UP. The phase detection component 10 is used to receive the external reference clock signal REF_CLK and the phase-rolling clock signal PHASE_WHIRL_CLK. When the phase of the phase-rolling clock signal PHASE_WHIRL_CLK leads the external reference clock signal REF_CLK, it generates the falling control signal DW. Conversely, when the phase of the phase-rolling clock signal PHASE_WHIRL_CLK lags the external reference clock signal REF_CLK, it generates the rising control signal UP.

In some embodiments, the phase detection component 10 includes a Phase Frequency Detector (PFD) and a charge pump. In other embodiments, the phase detection component may also be implemented using other structures with equivalent functions, without limitation in this regard.

In some embodiments, the loop filter component 30 has a falling control signal input terminal, a rising control signal input terminal, and a control voltage signal output terminal. The falling control signal input terminal of the loop filter component 30 is coupled to the falling control signal output terminal of the phase detection component 10, and is used to receive the falling control signal DW. The rising control signal input terminal of the loop filter component 30 is coupled to the rising control signal output terminal of the phase detection component 10, and is used to receive the rising control signal UP. The control voltage signal output terminal of the loop filter component 30 is coupled to the voltage-controlled oscillator component 50. The loop filter component 30 can be used to decrease the voltage value of the control voltage signal when it receives the falling control signal DW; and to increase the voltage value of the control voltage signal when it receives the rising control signal UP.

In some embodiments, the loop filter component 30 is a low-pass loop filter. It should be understood that the loop filter component 30 could also be implemented using other structures with equivalent functions, and those skilled in the art may select based on actual needs without limitation in this regard.

In some embodiments, the voltage-controlled oscillator component 50 has a control voltage input terminal and N oscillation clock signal output terminals. The control voltage input terminal of the voltage-controlled oscillator component 50 is coupled to the control voltage output terminal of the loop filter component 30, and is used to receive the control voltage signal. The multiple oscillation clock signal output terminals of the voltage-controlled oscillator component 50 are respectively coupled to the phase-rolling clock signal generation component 70, and are used to output multiple oscillation clock signals with uniformly varying phases, denoted as VCO_CLK<0> to VCO_CLK<N-1>. Based on the voltage value of the control voltage signal, the voltage-controlled oscillator component 50 can be configured to generate a plurality of oscillation clock signals with uniformly varying phases, denoted as VCO_CLK<0> to VCO_CLK<N-1>.

In some embodiments, the number of multiple oscillation clock signals VCO_CLK<0> to VCO_CLK<N-1> with uniformly varying phases is N, where N is a positive integer greater than or equal to 2. Here, the multiple oscillation clock signals VCO_CLK<0> to VCO_CLK<N-1> with uniformly varying phases share the same period, denoted as T. Moreover, between adjacent-phase oscillation clock signals VCO_CLK<P> and VCO_CLK<P+1> in the sequence of multiple oscillation clock signals VCO_CLK<0> to VCO_CLK<N-1> with uniformly varying phases, the phase difference is $\frac{1}{N}T$.

Here, P is an integer greater than or equal to 0 and less than or equal to N-2.

In some embodiments, the phase-rolling clock signal generator component 70 includes N oscillation clock signal input terminals and a feedback signal output terminal. The N oscillation clock signal input terminals of the phase-rolling clock signal generator component 70 are respectively coupled to the N oscillation clock signal output terminals of the voltage-controlled oscillator component 50, and are used to receive the N oscillation clock signal VCO_CLK<0> to VCO_CLK<N-1> with uniformly varying phases. The feedback signal output terminal of the phase-rolling clock signal generator component 70 is coupled to the feedback signal input terminal of the phase detection component 10, and is used to output the phase-rolling clock signal PHASE_WHIRL_CLK. The phase-rolling clock signal generator component 70 can be configured to perform integer frequency division on the N oscillation clock signals VCO_CLK<0> to VCO_CLK<N-1> with uniformly varying phases, thereby obtaining N feedback clock signals FB_CLK<0> to FB_CLK<N-1> with uniformly varying phases; Sort the N feedback clock signals FB_CLK<0> to FB_CLK<N-1> with uniformly varying phases according to their phase order, thereby determining their phase sequence; And according to a preset clock cycle, select feedback clock signals CLK_PHASE<k> with corresponding phase sequences k from the N feedback clock signals FB_CLK<0> to FB_CLK<N-1> with uniformly varying phases for concatenation, thereby generating the phase-rolling clock signal PHASE_WHIRL_CLK, where k is an integer greater than or equal to 0 and less than or equal to N-1.

In some embodiments, the target frequency of the N oscillation clock signals VCO_CLK<0> to VCO_CLK<N-1> with uniformly varying phases satisfies the following formula:

$$f_{VCO\_CLK} = f_{REF\_CLK} * (M + \frac{X}{N}) \qquad (1)$$

wherein, $f_{VCO\_CLK}$ represents the target frequency of the N oscillation clock signals VCO_CLK<0> to VCO_CLK<N-1> with uniformly varying phases, $f_{REF\_CLK}$ represents the frequency of the external reference clock signal REF_CLK, M represents the integer frequency division coefficient related to the target frequency of the N oscillation clock signals VCO_CLK<0> to VCO_CLK<N-1> with uniformly varying phases, X represents the numerator of the fractional division coefficient related to the target frequency of the N oscillation clock signals VCO_CLK<0> to VCO_CLK<N-1> with uniformly varying phases, and *X* is an integer greater than zero and less than or equal to (N-1).

As derived from the aforementioned Formula (1), when *X* is an integer greater than zero and less than or equal to (N-1), the target frequency $f_{VCO\_CLK}$ of the N oscillation clock signals VCO_CLK<0> to VCO_CLK<N-1> with uniformly varying phases equals $f_{REF\_CLK}$ multiplied by ( $M + \dfrac{X}{N}$ ) with respect to the external reference clock frequency $f_{REF\_CLK}$. In other words, when X is an integer greater than zero and less than or equal to (N-1), the phase-locked loop circuit disclosed in this embodiment operates as a fractional-N frequency division phase-locked loop circuit.

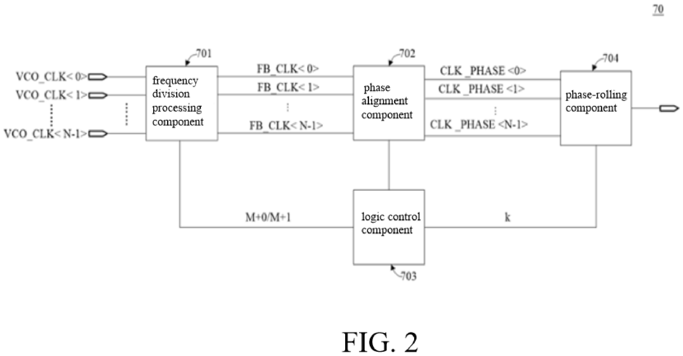

With reference to FIG. 2, in some embodiments, the phase-locked loop circuit is configured as a fractional-N frequency division phase-locked loop circuit. Specifically, when the target frequency $f_{VCO\_CLK}$ of the N oscillation clock signals VCO_CLK<0> to VCO_CLK<N-1> with uniformly varying phases equals the external reference clock frequency $f_{REF\_CLK}$ multiplied by ( $M + \dfrac{X}{N}$ ), the phase-rotating clock signal generation component 70 may comprise: A frequency division processing component 701, a phase alignment component 702, a logic control component 703, and a phase-rolling component 704.

The frequency division processing component 701 includes an integer frequency division coefficient input terminal, N oscillation clock signals input terminal and N feedback clock signals output terminal. The integer frequency division coefficient input terminal of the frequency division processing component 701 is coupled to the logic control component 703. The N oscillation clock signals input terminal of the frequency division processing component 701 are coupled to the N oscillation clock signals output terminal of the voltage-controlled oscillator component 50, and are used to receive the N oscillation clock signals VCO_CLK<0> to VCO_CLK<N-1> with uniformly varying phases. The N feedback clock signals output terminal of the frequency division processing component 701 are coupled to the N feedback clock signals input terminal of the phase alignment component 702, and are used to output the N feedback clock signals FB_CLK<0> to FB_CLK<N-1> with uniformly varying phases. The frequency division processing component 701 is configured to a corresponding integer frequency division coefficient and N phase-uniformly varying oscillation clock signals VCO_CLK<0> to VCO_CLK<N-1>; And perform frequency division processing on each of the N oscillation clock signals VCO_CLK<0> to VCO_CLK<N-1> using the integer frequency division coefficient, thereby obtaining N feedback clock signals FB_CLK<0> to FB_CLK<N-1> with uniformly distributed phases.

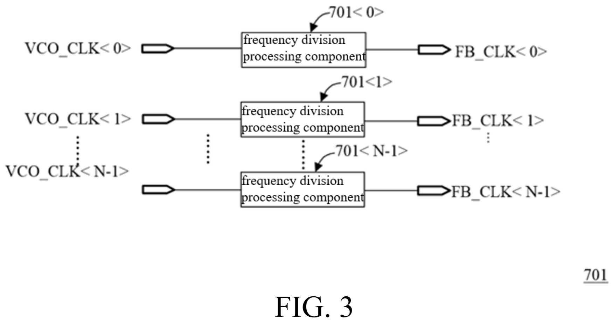

With reference to FIG. 3, in some embodiments, the frequency division processing component includes N frequency dividers 701<0> to 701<N-1> corresponding one-to-one to the N phase-uniformly varying oscillation clock signals VCO_CLK<0> to VCO_CLK<N-1>.

In other embodiments, the frequency division processing component may alternatively be implemented using other structures possessing equivalent functionality, which are not limited herein.

In some embodiments, the corresponding integer frequency division coefficient is (*M+0*) or (*M*+1) , which is specifically generated by the logic control component 703 according to the correspondence between the phase sequence *l* of the period of the phase-rolling clock signal PHASE_WHIRL_CLK and the phase sequence k of the feedback clock signal CLK_PHASE<k>. This will be elaborated in detail in the logic control component 703 later.

The phase alignment component 702 includes N feedback clock signals input terminal, N phase ordinal position output terminal, and a phase-rolling control signal output terminal. N feedback clock signals input terminal of the phase alignment component 702 are coupled to the N feedback clock signals output terminal of the frequency division processing component 701, and are used to receive N feedback clock signals FB_CLK<0> to FB_CLK<N-1> with uniformly varying phases. N phase ordinal position output terminal of the phase alignment component 702 are coupled to the phase-rolling component 704, and are used to output phase ordinal position of the N feedback clock signals FB_CLK<0> to FB_CLK<N-1> with uniformly varying phases. The phase-rolling control signal output terminal of the phase alignment component 702 is coupled to the logic control component 703, and is used to output the phase roll control signal PW_CLK. The phase alignment component 702 is configured to sort N feedback clock signals FB_CLK<0> to FB_CLK<N-1> with uniformly distributed phases according to their phase order, thereby determining phase ordinal positions of the N feedback clock signals FB_CLK<0> to FB_CLK<N-1>; and to perform a NOR operation on the N feedback clock signals to generate a phase-rolling control signal; CLK_PHASE<0> represents the feedback clock signals with phase ordinal position 0, CLK_PHASE<1> represents the feedback clock signals with phase ordinal position 1, ......, CLK_PHASE<N-1> represents the feedback clock signals with phase ordinal position (*N-1*).

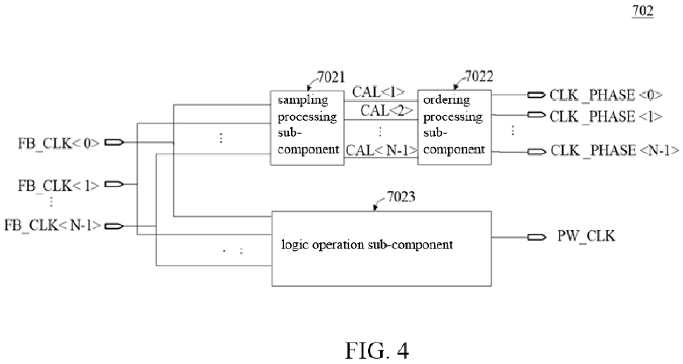

With reference to FIG. 4, in some embodiments, the phase alignment component 702 includes: a sampling processing sub-component 7021, a frequency division processing component 7022, and a logic operation sub-component 7023.

The sampling processing sub-component 7021 is configured to N feedback clock signal input terminals, and (N-1) sampled value output terminals. Specifically, the sampling processing sub-module 7021 includes N signal input terminals respectively configured to receive N feedback clock signals with FB_CLK<0> to FB_CLK<N-1 > with uniformly varying phases, and its (N-1) sampled value output terminals are used to output corresponding sampled signals. The sampling processing sub-component 7021 can be configured to sample the feedback clock signals FB_CLK<1> to FB_CLK<N-1> output by the frequency dividers 701<1> to 701<N-1> of the 1st to (N-1)th orders, respectively, using the feedback clock signal FB_CLK<0> output by the frequency divider 701<0> of the 0th order, thereby obtaining the corresponding sampled signals CAL<1> to CAL<N-1>.

The ordering processing sub-component 7022 is configured to (N-1) sampled value input terminals, and N signal input terminals. Specifically, the (N-1) sampled value input terminals of the ordering processing sub-component 7022 are coupled to the (N-1) sampled value output terminals of the sampling processing sub-component 7021 and configured to receive the corresponding sampled signals CAL<1> to CAL<N-1>, while its N signal output terminals are respectively configured to output phase ordinal positions of the N feedback clock signals with FB_CLK<0> to FB_CLK<N-1> with uniformly varying phases generated by the frequency dividers of the 0th to (N-1)th orders. The ordering processing sub-component 7022 can determine the phase ordinal positions of the N feedback clock signals with FB_CLK<0> to FB_CLK<N-1> with uniformly varying phases based on the sampled signals FB_CLK<0> to FB_CLK<N-1>.

The ordering processing sub-component 7022 is configured to determine the phase ordinal positions of the N phase-uniformly varying feedback clock signals based on the sampled signals using the following equation:

$$CLK\_PHASE < p > = \begin{cases} FB\_CLK < p+Y > & p+Y \leq N-1 \\ FB\_CLK < p+Y-N > & p+Y > N-1 \end{cases} \quad (2)$$

wherein, $CLK\_PHASE < p >$ represents the feedback clock signal whose phase order is $p$ when the N phase-uniformly-varying feedback clock signals are sorted in ascending order of phase, $FB\_CLK < p + Y >$ represents the feedback clock signal from the frequency divider at ordinal position $(p + Y)$, $FB\_CLK < p + Y - N >$ represents the feedback clock signal from the frequency divider at ordinal position $(p + Y - N)$, $Y$ represents the number of the second sampled value in the sampled signals, and $Y$ is an integer greater than or equal to 0 and less than or equal to $(N-1)$.

In some embodiments, the number of the second sampled value is 1.

In some embodiments, the logic operation sub-component 7023 is configured to N feedback clock signal input terminals, and the phase-rolling control signal output terminal. Specifically, the N feedback clock signal input terminals of the logic operation sub-component 7023 are configured to receive N feedback clock signals with FB_CLK<0> to FB_CLK<N-1> with uniformly varying phases, while its the phase-rolling control signal output terminal is coupled to the logic control component, and outputs the phase-rolling control signal PW_CLK. The logic operation sub-component 7023 is configured to perform a NOR logic operation on the N feedback clock signals with FB_CLK<0> to FB_CLK<N-1> with uniformly varying phases to generate the phase-rolling control signal PW_CLK.

In some embodiments, the logic operation sub-component 7023 is a NOR gate. In other embodiments, the logic operation sub-module may alternatively be implemented using other structures with equivalent functionality, which are not limited herein.

The logic control component 703 is configured to a phase-rolling control signal input terminal, a phase-rolling control signal output terminal, and an integer frequency division coefficient output terminal. Specifically, the phase-rolling control signal input terminal of the logic control component 703 is coupled to the phase-rolling control signal output terminal of the phase alignment component 702 and used to receive the phase-rolling control signal PW_CLK. The phase-rolling control signal output terminal of the logic control component 703 is coupled to the phase-rolling component 704 and used to output the phase-rolling control signal PW_CLK. The integer frequency division coefficient output terminal of the logic control component 703 is coupled to the frequency division processing component 701 and used to output the corresponding integer frequency division coefficient. The logic control component 703 can be configured to generate a phase selection control signal based on the clock cycles of the phase-rolling control signal PW_CLK and the phase-rolling clock signal PHASE_WHIRL_CLK, and the predetermined correspondence between the phase ordinal positions of the N feedback clock signals with FB_CLK<0> to FB_CLK<N-1> with uniformly varying phases. It can also be configured to generate the corresponding integer frequency division coefficient based on whether the clock cycles of the phase-rolling control signal PW_CLK and the phase-rolling clock signal PHASE_WHIRL_CLK satisfy a preset condition.

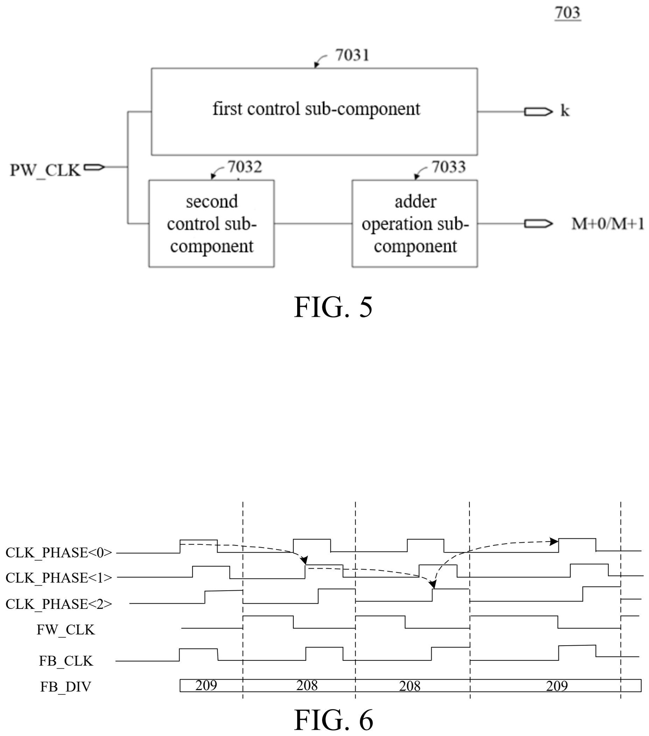

With reference to FIG. 5, in some embodiments, the logic control component 703 includes: a first control sub-component 7031, a second control sub-component 7032 and an adder operation sub-component 7033.

The first control sub-component 7031 is configured to a phase-rolling control signal input terminal and a phase-rolling control signal output terminal. Specifically, the phase-rolling control signal input terminal of the first control sub-component 7031 is used to receive the phase-rolling control signal PW_CLK, and the phase selection control signal output terminal of the first control sub-component 7031 is used to output the phase selection control signal. The first control sub-component 7031 can be configured to generate the phase selection control signal based on the clock cycles of the phase-rolling control signal PW_CLK and the phase-rolling clock signal PHASE_WHIRL_CLK, and the predetermined correspondence between the phase ordinal positions of the N feedback clock signals with FB_CLK<0> to FB_CLK<N-1> with uniformly varying phases.

Specifically, the first control sub-component 7031 is configured to obtain the phase ordinal position k of the feedback clock signal CLK_PHASE<k> output by the phase-rolling component 704 for each clock cycle *l* of the phase-rolling clock signal PHASE_WHIRL_CLK, based on the predetermined correspondence between the clock period of the phase-rolling clock signal PHASE_WHIRL_CLK and the phase ordinal position of the N feedback clock signals with FB_CLK<0> to FB_CLK<N-1> with uniformly varying phases. Within each clock cycle *l* of the phase-rolling clock signal PHASE_WHIRL_CLK, when the phase-rolling control signal PW_CLK is at the first logic level, the corresponding phase ordinal position k of the feedback clock signal CLK_PHASE<k> is output as the phase selection control signal.

Wherein, a preset correspondence between the clock cycles of the phase-rolling clock signal PHASE_WHIRL_*CLK* and the phase ordinal position of the N phase-uniformly varying feedback clock signals satisfies:

$$k = \begin{cases} l*X & 0 \le l*X < N \\ l*X - j_l * N & l*X \ge N \end{cases} \qquad (3)$$

$$j_l = \begin{cases} 0 & l=0 \\ j_{l-1} & 0 < l*X < j_{l-1}*N \\ j_{l-1}+1 & l*X \ge j_{l-1}*N \end{cases} \qquad (4)$$

wherein, *k* represents the phase order of the feedback clock signal output by the phase-rolling component 704 during the *l* th clock cycle of the phase-rolling clock signal, $j_l$ represents the carry count value of the integer frequency division coefficient *M* related to the target frequency of the oscillation clock signal during the *l*th clock cycle of the phase-rolling clock signal, $j_{l-1}$ represents the carry count value of the integer frequency division coefficient *M* related to the target frequency of the oscillation clock signal during the (*l* -1) th clock cycle of the phase roll clock signal.

The second control sub-component 7032 is configured to a phase-rolling control signal input terminal and a modulation value output terminal. Specifically, the phase-rolling control signal input terminal of the second control sub-component 7032 is used to receive the phase-rolling control signal PW_CLK, and the phase ordinal position output terminal of the second control sub-component 7032 is used to output the corresponding modulation value. The second control sub-component 7032 is configured to generate the corresponding modulation value based on whether the clock cycles of the phase-rolling control signal PW_CLK and the phase-rolling clock signal PHASE_WHIRL_CLK satisfy predefined conditions.

Specifically, the second control sub-component 7032 is configured to generate a first modulation value when the phase-rolling control signal PW_CLK is at the first logic level and the clock cycle of the phase-rolling clock signal PHASE_WHIRL_CLK satisfies preset condition $0 \le l*X < N$; and to generate the second modulation value when the phase-rolling control signal PW_CLK is at the second logic level and the clock cycle of the phase-rolling clock signal PHASE_WHIRL_CLK satisfies preset condition $l * X - j_{l-1} * N \ge N$. In some embodiments, the first modulation value is 0, and the second modulation value is 1.

The adder operation sub-component 7033 is configured to a modulation value input terminal and the integer frequency division coefficient output terminal. Specifically, the modulation value input terminal of the adder operation sub-component 7033 is used to receive the corresponding modulation value, and the integer frequency division coefficient output terminal of the adder operation sub-component 7033 is used to output the corresponding integer frequency-division coefficient. The adder operation sub-component 7033 can be used to calculate the sum of the corresponding modulation value and the integer division coefficient *M* related to the target frequency of the oscillation clock signal, thereby obtaining the corresponding integer frequency division coefficient.

Specifically, the adder operation sub-component 7033 is configured to calculate a sum of the integer frequency division coefficient *M* related to the target frequency of the oscillator clock signal and the first modulation value as a corresponding integer frequency division coefficient, upon receiving the first modulation value; and to calculate a sum of the integer frequency division coefficient *M* related to the target frequency of the oscillator clock signal and the second modulation value as a corresponding integer frequency division coefficient, upon receiving the second modulation value.

In some embodiments, the first modulation value is 0, and the second modulation value is 1. Accordingly, the corresponding integer frequency division coefficient is (*M* + 0) or *(M+1)*.

It is understood that the logic control component described above may also be implemented using other structures with the same functionality. Those skilled in the art may select the appropriate structure based on actual needs, and no restrictions are imposed herein.

The phase-rolling component 704 is configured to the phase-rolling control signal input terminal and N feedback clock signal input terminals. Specifically, the phase-rolling control signal input terminal of the phase-rolling component 704 is used to receive the phase-rolling control signal, and the N feedback clock signal input terminals of the phase-rolling component 704 are used to receive N feedback clock signals FB_CLK<0> to FB_CLK<N-1> with uniformly varying phases. The phase-rolling component 704 can be used to receive the phase rolling control signal and N feedback clock signals FB_CLK<0> to FB_CLK<N-1> with the phase uniformly varying; Based on the phase selection control signal, within each clock cycle of the feedback clock signals, the feedback clock signal CLK_PHASE<k> with the corresponding phase ordinal position k is selected from the N phase-uniformly varying feedback clock signals FB_CLK<0> to FB_CLK<N-1> for concatenation, thereby generating the phase rolling clock signal PHASE_WHIRL_CLK.

The following is a detailed description of the operating principle of the phase-locked loop circuit in the embodiment of the present invention.

It should be noted that the working principles of the phase detection component 10, loop filter component 30, and voltage-controlled oscillator component 50 in the phase-locked loop circuit of the present disclosure are the same as those of the corresponding component in existing phase-locked loop circuits, and therefore will not be described in detail here.

Unlike conventional phase-locked loop (PLL) circuits, in some embodiments, the phase-locked loop circuit employs a frequency division processing component 701, a phase alignment component 702, a logic control component 703, and a phase-rolling component 704 in the phase-rolling clock signal generator component 70. By applying corresponding integer frequency division coefficients to perform integer frequency division processing on each of the N oscillating clock signals VCO_CLK<0> to VCO_CLK<N-1> with uniformly varying phases, multiple feedback clock signals FB_CLK<0> to FB_CLK<N-1> with uniformly varying phases are obtained. These feedback clock signals are then sorted in phase order to determine their phase sequence. Finally, according to the preset clock cycle, the feedback clock signals CLK_PHASE<k> with the corresponding phase sequence are selected from the multiple feedback clock signals FB_CLK<0> to FB_CLK<N-1> with uniformly varying phases and concatenated to generate the phase-rolling clock signal PHASE_WHIRL_CLK, thereby achieving a fractional-N frequency division phase-locked loop.

Specifically, the frequency division processing component 701 receives N phase-uniformly varying oscillation clock signals VCO_CLK<0> to VCO_CLK<N-1>, and uses N frequency dividers with corresponding integer frequency division coefficients $(M+0)$ or $(M+1)$ to perform frequency division processing on the N phase-uniformly varying oscillation clock signals VCO_CLK<0> to VCO_CLK<N-1> respectively, to obtain N phase-uniform feedback clock signals FB_CLK<0> to FB_CLK<N-1>. Among them, the frequencies of the N phase-uniform feedback clock signals FB_CLK<0> to FB_CLK<N-1> are the same, and the phase differences between adjacent phase sequences of the feedback clock signals CLK_PHASE< Q> to CLK_PHASE<Q+1> are also the same, equal to $\frac{1}{3}T$. Here, Q is an integer less than or equal to N-2.

It should be noted that the N phase-uniformly varying feedback clock signals FB_CLK<0> to FB_CLK<N-1> output by the N frequency dividers 701<0> to 701<N-1> are identified by the corresponding frequency dividers in the bit order of the N frequency dividers 701<0> to 701<N-1>. Specifically, the feedback clock signal FB_CLK<0> is output from the 0th-order divider 701<0> among the N dividers 701<0> to 701<N-1>, the feedback clock signal FB_CLK<1> is output from the first-order divider 701<1> among the N dividers 701<0> to 701<N-1>, ..., the feedback clock signal FB_CLK<N-1> is output from the (N-1)th-order divider 701<N-1> among the N dividers 701<0> to 701<N-1>.

Subsequently, the N phase-uniformly varying feedback clock signals FB_CLK<0> to FB_CLK<N-1> output by the N frequency dividers 701<0> to 701<N-1> are input to the phase alignment component 702. The phase alignment component 702 sorts the N phase-uniformly varying feedback clock signals FB_CLK<0> to FB_CLK<N-1> in phase order, obtaining the phase sequence of the N phase-uniformly varying feedback clock signals FB_CLK<0> to FB_CLK<N-1>.

Specifically, the sampling processing sub-component 7021 samples the feedback clock signals FB_CLK<1> to FB_CLK<N-1> output by the dividers 701<1> to 701<N-1> with the 1st to (N-1)th order respectively using the feedback clock signal INTIAL_PHASE_WHIRL_CLK<0> output by the divider 701<0> of the 0th order, to obtain the corresponding sampling signals CAL<1> to CAL<N-1>.

The ordering processing sub-component 7022 receives the corresponding sampling signals CAL<1> to CAL<N-1> and obtains the phase order of N feedback clock signals FB_CLK<0> to FB_CLK<N-1> with uniformly varying phases based on the corresponding sampling signals CAL<1> to CAL<N-1>.

Specifically, as shown in Formula (2), when the corresponding sampling signals CAL<1> to CAL<N-1> are all the first sampling values, the ordering processing sub-component 7022 determines that the phase order of the N phase-uniformly varying feedback clock signals FB_CLK<0> to FB_CLK<N-1> is the same as the bit order of the N dividers 701<0> to 701<N-1>. Wherein, the first sampling value is 0.

As shown in Formula (2), when there is a unique second sampling value for the corresponding sampling signals CAL<1> to CAL<N-1>, the phase sequence of the feedback clock signal FB_CLK<1> output by the first-order divider 701<1> is 0, the phase sequence of the feedback clock signal FB_CLK<2> output by the second-order divider is 1, ..., the phase sequence of the feedback clock signal FB_CLK<N-2> output by the (N-2)th-order divider is N-1, and the phase sequence of the feedback clock signal FB_CLK<N-1> output by the (N-1)th-order divider is 0. Here, the second sampling value is 1.

When there are two or more second sampling values in the corresponding sampling signals CAL<1> to CAL<N-1>, the phase sequence of the feedback clock signals output by each frequency divider can be obtained separately using the above formula (2).

It should be noted that after obtaining the phase sequence of N feedback clock signals FB_CLK<0> to FB_CLK<N-1> with uniformly varying phases, CLK_PHASE<0> to CLK_PHASE<N-1> are used to identify the N feedback clock signals FB_CLK<0> to FB_CLK<N-1> with uniformly varying phases, respectively. Among these, CLK_PHASE<0> is used to represent the feedback clock signal with phase sequence 0, CLK_PHASE<1> is used to represent the feedback clock signal with phase sequence 1, ..., and CLK_PHASE<N-1> is used to represent the feedback clock signal with phase sequence N-1.

Meanwhile, the frequency division processing component 7023 performs NOR logic operations on the N phase-uniformly varying feedback clock signals FB_CLK<0> to FB_CLK<N-1> to obtain the phase-rolling control signal PW_CLK. Specifically, when all N phase-uniformly varying feedback clock signals FB_CLK<0> to FB_CLK<N-1> have the first logic level, the phase-rolling control signal PW_CLK has the second logic level; when at least one of the N feedback clock signals FB_CLK<0> to FB_CLK<N-1> with uniformly varying phases has the second logic level, the phase-rolling control signal PW_CLK has the first logic level. Here, the first logic level is a low level, and the second logic level is a high level.

The logic operation sub-component 7023 performs NOR logic operations on the N phase-uniformly varying feedback clock signals FB_CLK<0> to FB_CLK<N-1>, generating the phase-rolling control signal PW_CLK. This ensures that all N phase-uniformly varying feedback clock signals FB_CLK<0> to FB_CLK<N-1> are in a stable state, that is, avoiding the rising and falling edges of the N phase-uniformly varying feedback clock signals FB_CLK<0> to FB_CLK<N-1>, to generate the corresponding integer frequency division coefficients used by the frequency division processing component 701 to perform integer frequency division processing on the N phase-uniformly varying oscillation clock signals VCO_CLK<0> to VCO_CLK<N-1>, such as ($M$ +0) or ($M$ +1).

After obtaining the phase sequence of N feedback clock signals FB_CLK<0> to FB_CLK<N-1> with uniformly varying phases, the first control sub-component 7031 in the logic control component 703 generates a phase selection control signal based on the predefined correspondence between the clock cycles of the phase-rolling control signal PW_CLK and the phase-rolling control signal PHASE_WHIRL_CLK, and the phase sequence of the N feedback clock signals FB_CLK<0> to FB_CLK<N-1> with uniformly varying phases generates a phase selection control signal.

Specifically, the first control sub-component 7031 determines the phase-rolling control signal PHASE_WHIRL_CLK based on the clock cycle and the predefined correspondence between the phase sequence of the N feedback clock signals FB_CLK<0> to FB_CLK<N-1> with uniformly varying phases, obtains the phase sequence k of the feedback clock signal CLK_PHASE<k> output by the phase-rolling component 704 for each clock cycle of the phase rolling clock signal PHASE_WHIRL_CLK according to formulas (3) and (4); According to the predefined clock cycle, when the phase-rolling control signal PW_CLK is at the first logic level, the phase sequence k of the corresponding feedback clock signal CLK_PHASE<k> is output as the phase selection control signal.

Meanwhile, the second control sub-component 7032 in the logic control component 703 generates a first modulation value when the phase roll control signal PW_CLK has a first logic level and the clock period of the phase roll clock signal PHASE_WHIRL_CLK satisfies the predetermined condition $0 \le I * X < N$. When the phase roll control signal PW_CLK is at the first logic level and the clock period of the phase roll clock signal PHASE_WHIRL_CLK satisfies the predefined condition $I * X - j_{I-1} * N \ge N$, the second modulation value is generated, where $I$ represents the clock period of the phase-rolling clock signal. For example, the first modulation value is 0, and the second modulation value is 1.

Subsequently, upon receiving the first modulation value, the adder operation sub-component 7033 calculates the sum of the first modulation value and the integer frequency division coefficient $M$ related to the target frequency of the oscillation clock signal, obtaining the corresponding integer frequency division coefficient of ($M$ + 0) ; upon receiving the second modulation value, the sum of the second modulation value and the integer frequency division coefficient $M$ related to the target frequency of the oscillation clock signal is calculated, obtaining the corresponding integer frequency division coefficient of ($M$ + 1) , such that the frequency division processing module 701 performs integer frequency division processing on the N phase-uniformly varying oscillation clock signals VCO_CLK<0> to VCO_CLK<N-1> using the corresponding integer frequency division coefficients, thereby obtaining the N phase-uniformly varying feedback clock signals FB_CLK<0> to FB_CLK<N-1>.

Subsequently, the phase-rolling component 704, within each cycle of the phase-rolling clock signal PHASE_WHIRL_CLK, selects the feedback clock signal CLK_PHASE<k> with phase sequence k received as the phase-rolling control signal, and outputs the phase-rolling clock signal PHASE_WHIRL_CLK<k> from the N phase uniformly varying feedback clock signals FB_CLK<0> to FB_CLK<N -1>, thereby generating ( $M + \dfrac{X\grave{}}{N\grave{}}$ ) oscillation clock signal

VCO_CLK periods between adjacent rising edges of the phase-rolling clock signal PHASE_WHIRL_CLK output by the phase-rolling component 704.

Referring to FIG. 6, taking an external reference clock signal frequency of 24 Hz, N = 3, and X = 1 as an example, when the target frequency $f_{vco\_clk\_out}$ of the oscillating clock signal output by the phase-locked loop circuit is 5 GHz, the integer frequency division coefficient $M$ related to the target frequency of the oscillating clock signal can be calculated as 208 according to formula (1). That is, when the phase-locked loop circuit is in the locked state, the adjacent rising edges of the phase-rolling clock signal PHASE_WHIRL_CLK generated by the phase-rolling clock signal generation component 70 require ( $208 + \dfrac{1}{3}$ ) cycles of the oscillating clock signal VCO_CLK.

The values of the relevant parameters within the 0th to 8th cycles of the phase-rolling clock signal PHASE_WHIRL_CLK are shown in Table 1 below.

Table 1

| I | I* X | N | $j_I$ | CLK _PHASE<k> | M + 0 / M + 1 |
|---|------|---|-------|---------------|---------------|
| 0 | 0 | 3 | 0 | 0 | 208 |
| 1 | 1 | 3 | 0 | 1 | 208 |
| 2 | 2 | 3 | 0 | 2 | 208 |
| 3 | 3 | 3 | 1 | 0 | 209 |
| 4 | 4 | 3 | 1 | 1 | 208 |
| 5 | 5 | 3 | 1 | 2 | 208 |
| 6 | 6 | 3 | 2 | 0 | 209 |
| 7 | 7 | 3 | 2 | 1 | 208 |
| 8 | 8 | 3 | 2 | 2 | 208 |

Please refer to FIG. 6 and Table 1. During the 0th, 1st, and 2nd cycles of the phase-rolling clock signal PHASE_WHIRL_CLK, the frequency division processing component 701 applies the corresponding integer frequency division coefficients 208 to the 3 phase-uniformly varying oscillation clock signals VCO_CLK<0>, VCO_CLK<1>, and VCO_CLK<2>, respectively, to perform integer frequency division processing, thereby obtaining the 3 phase-uniformly varying feedback clock signals FB_CLK<0>, FB_CLK<1>, and FB_CLK<2>. At this point, there are 208 oscillation clock signal periods between the adjacent rising edges of the feedback clock signals FB_CLK<0>, FB_CLK<1>, and FB_CLK<2>.

At the same time, during the 0th, 1st, and 2nd cycles of the phase-rolling clock signal PHASE_WHIRL_CLK, the phase-rolling component 704 selects the feedback clock signal CLK_PHASE<0> with phase sequence 0, the feedback clock signal CLK_PHASE<1> with phase sequence 1, and the feedback clock signal CLK_PHASE<2> with phase sequence 2 for output, that is, it jumps from the feedback clock signal CLK_PHASE<0> with phase sequence 0 to the feedback clock signal CLK_PHASE<1> with phase sequence 1, and then from the feedback clock signal CLK_PHASE<1> with phase sequence 1 to the feedback clock signal CLK_PHASE<2> with phase sequence 2. Since the feedback clock signal CLK_PHASE<1> with phase sequence 1 is delayed by $\dfrac{1}{3}$ oscillation clock signal VCO_CLK periods T compared to the feedback clock signal CLK_PHASE<0> with phase sequence 0, and the feedback clock signal CLK_PHASE<2> with phase sequence 2 is delayed by $\dfrac{1}{3}$ periods T of the oscillation clock signal VCO_CLK relative to the feedback clock signal CLK_PHASE<1> with phase sequence 1, such that between the rising edges of the phase-rolling clock signal PHASE_WHIRL_CLK in the 0th, the first cycle, and the second cycle, there are ( $208 + \dfrac{1}{3}$ ) periods T of the oscillation clock signal VCO_CLK between the rising edges of the phase-rolling clock signal PHASE_WHIRL_CLK.

During the third cycle of the phase-rolling clock signal PHASE_WHIRL_CLK, the frequency division processing component 701 applies the corresponding integer frequency division coefficient 209 to perform integer frequency division processing on the phase-uniformly varying oscillation clock signals VCO_CLK<0>, VCO_CLK<1>, and VCO_CLK<2>, respectively, to obtain three phase-uniformly varying feedback clock signals FB_CLK<0>, FB_CLK<1>, and FB_CLK<2>. At this point, there are 209 oscillation clock signal periods between the adjacent rising edges of the feedback clock signals FB_CLK<0>, FB_CLK<1>, and FB_CLK<2>.

At the same time, during the third cycle of the phase-rolling clock signal, the phase-rolling component 704 selects the feedback clock signal CLK_PHASE<0> with a phase sequence of 0 for output, that is, it jumps from the feedback clock signal CLK_PHASE<2> with a phase sequence of 2 to the feedback clock signal $_{CLK}$PHASE<0> with a phase sequence of 0. Since, during the third cycle of the phase-rolling clock signal, the feedback clock signal CLK_PHASE<0> with phase sequence 0 leads the feedback clock signal CLK_PHASE<2> with phase sequence 2 by $\frac{2}{3}$ cycles of the oscillation clock signal VCO_CLK, resulting in ( $209 - \frac{2}{3} = 208 + \frac{1}{3}$ ) cycles of the oscillation clock signal VCO_CLK periods T between the rising edges of the phase-rolling clock signal in the third cycle.

Similarly, during the 4th to 8th cycles of the phase-rolling clock signal PHASE_WHIRL_CLK, ( $208 + \frac{1}{3}$ ) cycles of the oscillating clock signal VCO_CLK are generated between the rising edges of the phase-rolling clock signal, thereby implementing a fractional-N frequency division phase-locked loop.

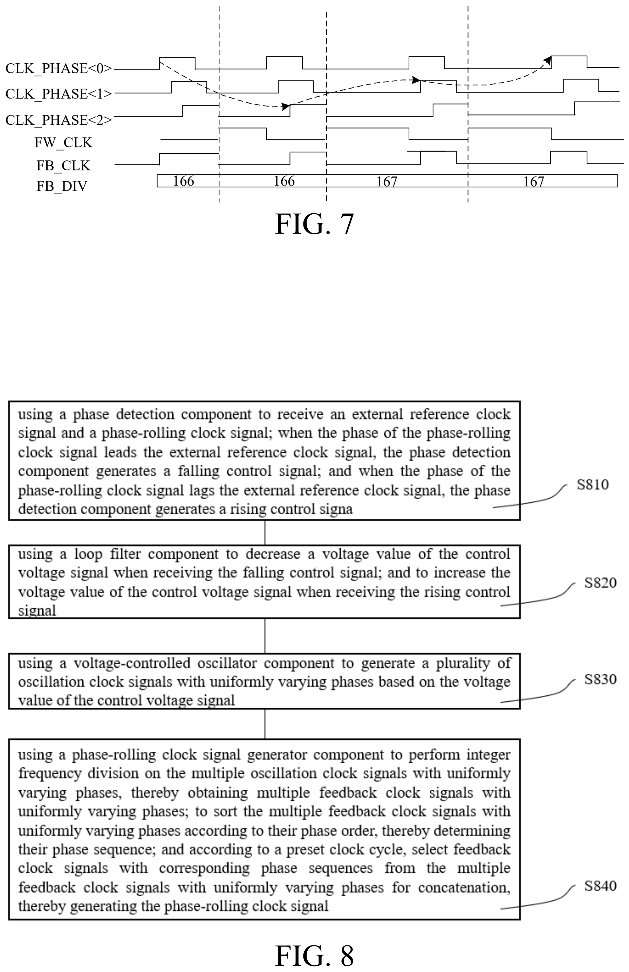

Referring to FIG. 7, taking an external reference clock signal frequency of 24 Hz, N = 3, and X = 2 as an example, when the target frequency $f_{vco\_clk\_out}$ of the oscillating clock signal output by the phase-locked loop circuit is 4 GHz, the integer frequency division coefficient $M$ related to the target frequency of the oscillating clock signal can be calculated using formula (1) to be 166. That is, when the phase-locked loop circuit is in the locked state, the adjacent rising edges of the phase-rolling clock signal PHASE_WHIRL_CLK generated by the phase-rolling clock signal generation component 70 require ( $166 + \frac{2}{3}$ ) cycles of the oscillating clock signal VCO_CLK.

The values of the relevant parameters within the 0th to 6th cycles $l$ of the phase-rolling clock signal PHASE_WHIRL_CLK are shown in Table 2 below.

Table 2

| $l$ | $l * X$ | $N$ | $j_l$ | CLK_PHASE<$k$> | $M + 0 / M + 1$ |
|---|---|---|---|---|---|
| 0 | 0 | 3 | 0 | 0 | 166 |
| 1 | 2 | 3 | 0 | 2 | 166 |
| 2 | 4 | 3 | 2 | 1 | 167 |
| 3 | 6 | 3 | 2 | 0 | 167 |
| 4 | 8 | 3 | 2 | 2 | 166 |
| 5 | 10 | 3 | 3 | 1 | 167 |
| 6 | 12 | 3 | 4 | 0 | 167 |

Please refer to FIG. 7 and Table 2. During the 0th and 1st cycles of the phase-rolling clock signal PHASE_WHIRL_CLK, the frequency division processing component 701 applies the corresponding integer frequency division coefficient 166 to the 3 phase-uniformly varying oscillator clock signals VCO_CLK<0>, VCO_CLK<1>, and VCO_CLK<2>, respectively, to perform integer frequency division processing, thereby obtaining the 3 phase-uniformly varying feedback clock signals FB_CLK<0>, FB_CLK<1>, and FB_CLK<2>. At this point, there are 166 oscillation clock signal cycles between the adjacent rising edges of the three phase-uniformly varying feedback clock signals FB_CLK<0>, FB_CLK<1>, and FB_CLK<2>.

At the same time, during the 0th and 1st cycles of the phase-rolling clock signal PHASE_WHIRL_CLK, the phase-rolling component 704 selects the feedback clock signal CLK_PHASE<0> with phase sequence 0 and the feedback clock signal CLK_PHASE<2> with phase sequence 2 for output, that is, it jumps from the feedback clock signal CLK_PHASE<0> with phase sequence 0 to the feedback clock signal CLK_PHASE<2> with phase sequence 2. Since the feedback clock signal CLK_PHASE<2> with a phase sequence of 2 is delayed by $\frac{2}{3}$ periods T of the oscillation clock signal VCO_CLK compared to the feedback clock signal CLK_PHASE<0> with a phase sequence of 0, this results in ( $166+\dfrac{2}{3}$ ) periods of the oscillation clock signal VCO_CLK being generated between the rising edges of the phase-rolling clock signal PHASE_WHIRL_CLK in the 0th and 1st cycles.

During the second cycle of the phase-rolling clock signal PHASE_WHIRL_CLK, the frequency division processing component 701 applies the corresponding integer frequency division coefficient 167 to the three phase-uniformly varying oscillation clock signals VCO_CLK<0>, VCO_CLK<1>, and VCO_CLK<2>, respectively, to perform integer frequency division processing, thereby obtaining the three phase-uniformly varying feedback clock signals FB_CLK<0>, FB_CLK<1>, and FB_CLK<2>. At this point, there are 167 oscillation clock signal cycles between the adjacent rising edges of the three phase-uniformly varying feedback clock signals FB_CLK<0>, FB_CLK<1>, and FB_CLK<2>.

At the same time, during the second cycle of the phase-rolling clock signal, the phase-rolling component 704 selects the feedback clock signal CLK_PHASE<1> with phase sequence 1 for output, that is, it jumps from the feedback clock signal CLK_PHASE<2> with phase sequence 2 to the feedback clock signal CLK_PHASE<1> with phase sequence 1. Since during the second cycle of the phase-rolling clock signal, the feedback clock signal CLK_PHASE<1> with phase sequence 1 leads the feedback clock signal CLK_PHASE<2> with phase sequence 2 by $\dfrac{1}{3}$ cycles of the oscillation clock signal VCO_CLK, resulting in ( $167-\dfrac{1}{3}=166+\dfrac{2}{3}$ ) cycles of the oscillation clock signal VCO_CLK between the rising edges of the phase-rolling clock signal in the third cycle.

Similarly, during the third to sixth cycles of the phase-rolling clock signal PHASE_WHIRL_CLK, the rising edges of the phase-rolling clock signal generate ( $166+\dfrac{2}{3}$ ) cycles of the oscillation clock signal VCO_CLK, thereby implementing a fractional-N frequency division phase-locked loop.

In summary, the phase-locked loop circuit in the embodiment of the present disclosure can realize a fractional-N frequency division phase-locked loop in the case of using a frequency division processing component 701 with integer frequency division. Compared with the method of realizing a fractional-N frequency division phase-locked loop using a digital Σ-Δ modulator, it can save the area occupied by the phase-locked loop circuit and power consumption, thereby helping to improve the performance of the phase-locked loop circuit.

Accordingly, the present disclosure also provides a phase-locking method.

FIG. 8 shows a flowchart illustrating an embodiment of the phase-locking method provided by the technical solution disclosed herein. With reference to FIG. 8, a phase-locking method may specifically include the following steps:

Step S810: using a phase detection component to receive an external reference clock signal and a phase-rolling clock signal; when the phase of the phase-rolling clock signal leads the external reference clock signal, the phase detection component generates a falling control signal; and when the phase of the phase-rolling clock signal lags the external reference clock signal, the phase detection component generates a rising control signal;

Step S820: using a loop filter component is used to decrease a voltage value of the control voltage signal when receiving the falling control signal; and to increase the voltage value of the control voltage signal when receiving the rising control signal;

Step S830: using a voltage-controlled oscillator component is used to generate a plurality of oscillation clock signals with uniformly varying phases based on the voltage value of the control voltage signal; and

Step S840: using a phase-rolling clock signal generator component is used to perform integer frequency division on the multiple oscillation clock signals with uniformly varying phases, thereby obtaining multiple feedback clock signals with uniformly varying phases; to sort the multiple feedback clock signals with uniformly varying phases according to their phase order, thereby determining their phase sequence; and according to a preset clock cycle, select feedback clock signals with corresponding phase sequences from the multiple feedback clock signals with uniformly varying phases for concatenation, thereby generating the phase-rolling clock signal.

The phase-locking method in the embodiments of the present disclosure may be performed by the phase-locked loop circuit described above, or may also be performed by other functional modules. For details on the phase-locked loop circuit, please refer to the detailed description in the preceding section.

Accordingly, the present disclosure also provides a frequency synthesizer that includes the phase-locked loop circuit provided by the present disclosure. For details regarding the phase-locked loop circuit, please refer to the detailed description in the preceding section, and no further description will be provided here.

The foregoing descriptions of the disclosed embodiments enable a person skilled in the art to implement or use the present disclosure. Various modifications to these embodiments are apparent to a person skilled in the art, and general principles defined in this specification may be implemented in other embodiments without departing from the spirit or scope of the present disclosure. Therefore, the present disclosure is not to be limited to these embodiments described herein, but accords with the widest scope consistent with the principles and novel features disclosed herein.

Although the present disclosure is disclosed above, the present disclosure is not limited thereto. A person skilled in the art can make various changes and modifications without departing from the spirit and the scope of the present disclosure. Therefore, the protection scope of the present disclosure should be subject to the scope defined by the claims.

**Claims**

1. A phase-locked loop circuit, comprising:

   a phase detection component, configured to receive an external reference clock signal and a phase-rolling clock signal; when the phase of the phase-rolling clock signal leads the external reference clock signal, the phase detection component generates a falling control signal; and when the phase of the phase-rolling clock signal lags the external reference clock signal, the phase detection component generates a rising control signal;
   a loop filter component, configured to decrease a voltage value of the control voltage signal when receiving the falling control signal; and to increase the voltage value of the control voltage signal when receiving the rising control signal;
   a voltage-controlled oscillator component, configured to generate a plurality of oscillation clock signals with uniformly varying phases based on the voltage value of the control voltage signal; and
   a phase-rolling clock signal generator component, configured to perform integer frequency division on the multiple oscillation clock signals with uniformly varying phases, thereby obtaining multiple feedback clock signals with uniformly varying phases; sort the multiple feedback clock signals with uniformly varying phases according to their phase order, thereby determining their phase sequence; and according to a preset clock cycle, select feedback clock signals with corresponding phase sequences from the multiple feedback clock signals with uniformly varying phases for concatenation, thereby generating the phase-rolling clock signal.

2. The phase-locked loop circuit according to claim 1, wherein a target frequency of the oscillation clock signal satisfies:

$$f_{VCO\_CLK} = f_{REF\_CLK} * (M + \frac{X}{N});$$

   wherein, $f_{VCO\_CLK}$ represents the target frequency of the oscillation clock signal, $f_{REF\_CLK}$ represents the frequency of the external reference clock signal, $M$ represents the integer frequency division coefficient related to the target frequency of the oscillation clock signal, $X$ represents the numerator of the fractional division coefficient related to the target frequency of the oscillation clock signal, $X$ is an integer greater than zero and less than or equal to (N-1), $N$ represents the number of multiple feedback clock signals with uniformly varying phases.

3. The phase-locked loop circuit according to claim 2, wherein a phase-rolling clock signal generator component includes:

   a frequency division processing component, configured to receive a corresponding integer frequency division coefficient and N phase-uniformly varying oscillation clock signals; and perform frequency division processing on each of the N oscillation clock signals using the integer frequency division coefficient, thereby obtaining N feedback clock signals with uniformly distributed phases;
   a phase alignment component, configured to sort N feedback clock signals with uniformly distributed phases according to their phase order, thereby determining phase ordinal positions of the N feedback clock signals; and to perform a NOR operation on the N feedback clock signals to generate a phase-rolling control signal;
   a logic control component, configured to generate a phase selection control signal according to the phase-rolling control signal, and a preset correspondence between a clock cycle of the phase-rolling clock signal and phase ordinal positions of the N phase-uniformly varying feedback clock signals; and also configured to generate a corresponding integer frequency division coefficient based on a preset condition satisfied by the clock cycle of the phase-rolling clock signal and the phase-rolling control signal; and
   a phase-rolling component, configured to receive the phase-rolling control signal and N phase-uniformly varying feedback clock signals; and at each clock cycle of the phase-rolling clock signal, select and concatenate feedback clock signals with corresponding phase ordinal positions from the N phase-uniformly varying feedback clock signals according to the phase selection control signal, thereby generating the phase-rolling clock signal.

4. The phase-locked loop circuit according to claim 3, wherein the frequency division processing component includes N frequency dividers corresponding one-to-one to the N phase-uniformly varying oscillation clock signals;
the frequency dividers, configured to receive a corresponding integer frequency division coefficient and a corresponding one of N phase-uniformly varying oscillation clock signals; and perform frequency division processing on the corresponding oscillation clock signal using the integer frequency division coefficient, thereby obtaining a corresponding feedback clock signal.

5. The phase-locked loop circuit according to claim 4, wherein the phase alignment component includes:

a sampling processing sub-component, configured to use a feedback clock signal from a frequency divider at ordinal position 0 to sample and process the feedback clock signals from the frequency dividers at ordinal positions 1 to (N-1), thereby obtaining the corresponding sampled signals;
an ordering processing sub-component, configured to determine phase ordinal positions of the N phase-uniformly varying feedback clock signals based on the sampled signals;
a logic operation sub-component, configured to perform a NOR logic operation on the N phase-uniformly varying feedback clock signals, thereby obtaining the phase-rolling control signal.

6. The phase-locked loop circuit according to claim 5, wherein the ordering processing sub-component is configured to determine phase ordinal positions of the N phase-uniformly varying feedback clock signals based on the sampled signals using the following equation:

$$CLK\_PHASE<p>=\begin{cases} FB\_CLK<p+Y> & p+Y \leq N-1 \\ FB\_CLK<p+Y-N> & p+Y > N-1 \end{cases}$$

wherein, $CLK\_PHASE<p>$ represents the feedback clock signal whose phase order is $p$ when the N phase-uniformly-varying feedback clock signals are sorted in ascending order of phase, $FB\_CLK<p+Y>$ represents the feedback clock signal from the frequency divider at ordinal position $(p+Y)$, $FB\_CLK<p+Y-N>$ represents the feedback clock signal from the frequency divider at ordinal position $(p+Y-N)$, $Y$ represents the number of the second sampled value in the sampled signals, and $Y$ is an integer greater than or equal to 0 and less than or equal to $(N-1)$.

7. The phase-locked loop circuit according to claim 3, wherein the number of the second sampled value is 1.

8. The phase-locked loop circuit according to claim 6, wherein the logic control component includes:

a first control sub-component, configured to generate a phase selection control signal according to the phase roll control signal, and a preset correspondence between the clock cycles of the phase-rolling clock signal and the phase ordinal positions of the N phase-uniformly varying feedback clock signals;
a second control sub-component, configured to generate corresponding modulation values based on a preset condition satisfied by the clock cycle of the phase-rolling clock signal and the phase-rolling control signal; and
an adder operation sub-component, configured to calculate the sum of the corresponding modulation value and the integer division coefficient related to the target frequency of the oscillation clock signal, thereby obtaining the corresponding integer frequency division coefficient.

9. The phase-locked loop circuit according to claim 8, wherein the first control sub-component, configured to obtain the phase order of the feedback clock signals output by the phase-rolling component in each clock cycle of the phase roll clock signal, based on the preset correspondence between the clock cycles of the phase roll clock signal and the phase order of the N phase-uniformly varying feedback clock signals; and output the phase order of the corresponding feedback clock signal as the phase selection control signal during the preset clock cycle when the phase roll control signal has a first logic level;

wherein a preset correspondence between the clock cycles of the phase roll clock signal and the phase order of the N phase-uniformly varying feedback clock signals satisfies:

$$k = \begin{cases} l*X & 0 \le l*X < N \\ l*X - j_l*N & l*X \ge N \end{cases};$$

and

$$j_l = \begin{cases} 0 & l=0 \\ j_{l-1} & 0 < l*X < j_{l-1}*N \\ j_{l-1}+1 & l*X \ge j_{l-1}*N \end{cases};$$

wherein, $k$ represents the phase order of the feedback clock signal output by the phase-rolling component during the $l$-th clock cycle of the phase roll clock signal, $j_l$ represents the carry count value of the integer frequency division coefficient related to the target frequency of the oscillation clock signal during the $l$-th clock cycle of the phase roll clock signal, $j_{l-1}$ represents the carry count value of the integer frequency division coefficient $M$ related to the target frequency of the oscillation clock signal during the $(l-1)$-th clock cycle of the phase roll clock signal.

10. The phase-locked loop circuit according to claim 8, wherein the second control sub-component, configured to generate a first modulation value when the phase-rolling control signal is at a first logic level and the clock cycle of the phase-rolling clock signal satisfies preset condition $0 \le i*X < N$; and to generate a second modulation value when the phase-rolling control signal is at a first logic level and the clock cycle of the phase-rolling clock signal satisfies preset condition $l*X - j_{l-1}*N \ge N$;

the adder operation sub-component, configured to calculate a sum of the integer frequency division coefficient $M$ related to the target frequency of the oscillator clock signal and the first modulation value as a corresponding integer frequency division coefficient, upon receiving the first modulation value; and to calculate a sum of the integer frequency division coefficient $M$ related to the target frequency of the oscillator clock signal and the second modulation value as a corresponding integer frequency division coefficient, upon receiving the second modulation value.

11. The phase-locked loop circuit according to claim 10, wherein the first modulation value is 0, and the second modulation value is 1.

12. The phase-locked loop circuit according to claim 10, wherein the first logic level is defined as a low level.

13. A phase-locking method, comprising:

using a phase detection component to receive an external reference clock signal and a phase-rolling clock signal; when the phase of the phase-rolling clock signal leads the external reference clock signal, the phase detection component generates a falling control signal; and when the phase of the phase-rolling clock signal lags the external reference clock signal, the phase detection component generates a rising control signal;
using a loop filter component to decrease a voltage value of the control voltage signal when receiving the falling control signal; and to increases the voltage value of the control voltage signal when receiving the rising control signal;
using a voltage-controlled oscillator component to generate a plurality of oscillation clock signals with uniformly varying phases based on the voltage value of the control voltage signal; and
using a phase-rolling clock signal generator component to perform integer frequency division on the multiple oscillation clock signals with uniformly varying phases, thereby obtaining multiple feedback clock signals with uniformly varying phases; to sort the multiple feedback clock signals with uniformly varying phases according to their phase order, thereby determining their phase sequence; and according to a preset clock cycle, select feedback clock signals with corresponding phase sequences from the multiple feedback clock signals with uniformly varying phases for concatenation, thereby generating the phase-rolling clock signal.

14. A frequency synthesizer, comprising the phase-locked loop circuit according to any one of claims 1 to 12.

FIG. 1

FIG. 2

VCO_CLK< 0> ⬠ —— 701< 0> frequency division processing component ⬠ FB_CLK< 0>

VCO_CLK< 1> ⬠ —— 701< 1> frequency division processing component ⬠ FB_CLK< 1>

VCO_CLK< N-1> ⬠ —— 701< N-1> frequency division processing component ⬠ FB_CLK< N-1>

701

# FIG. 3

702

FIG. 4

FIG. 5

FIG. 6

FIG. 7

using a phase detection component to receive an external reference clock signal and a phase-rolling clock signal; when the phase of the phase-rolling clock signal leads the external reference clock signal, the phase detection component generates a falling control signal; and when the phase of the phase-rolling clock signal lags the external reference clock signal, the phase detection component generates a rising control signa — S810

using a loop filter component to decrease a voltage value of the control voltage signal when receiving the falling control signal; and to increase the voltage value of the control voltage signal when receiving the rising control signal — S820

using a voltage-controlled oscillator component to generate a plurality of oscillation clock signals with uniformly varying phases based on the voltage value of the control voltage signal — S830

using a phase-rolling clock signal generator component to perform integer frequency division on the multiple oscillation clock signals with uniformly varying phases, thereby obtaining multiple feedback clock signals with uniformly varying phases; to sort the multiple feedback clock signals with uniformly varying phases according to their phase order, thereby determining their phase sequence; and according to a preset clock cycle, select feedback clock signals with corresponding phase sequences from the multiple feedback clock signals with uniformly varying phases for concatenation, thereby generating the phase-rolling clock signal — S840

FIG. 8

## EUROPEAN SEARCH REPORT

**Application Number**

EP 25 21 2163

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/168290 A1 (PARIKH PARAG [US]) 4 August 2005 (2005-08-04) | 1,2,13, 14 | INV. H03L7/08 |
| A | * paragraph [0036] - paragraph [0073]; figures 2-5 * | 3-12 | H03L7/099 H03L7/18 |
| | ----- | | |
| X | US 8 952 736 B1 (EVANS KEN [US] ET AL) 10 February 2015 (2015-02-10) | 1,2,13, 14 | |
| A | * column 5, line 27 - column 14, line 58; figures 2-6 * | 3-12 | |
| | ----- | | |
| A | US 2015/381191 A1 (WU MICHAEL A [US] ET AL) 31 December 2015 (2015-12-31) * paragraph [0020] - paragraph [0072]; figures 2-6 * | 1-14 | |
| | ----- | | |

**TECHNICAL FIELDS SEARCHED (IPC)**

H03L

The present search report has been drawn up for all claims

| Place of search | Date of completion of the search | Examiner |
|---|---|---|
| The Hague | 20 March 2026 | Wienema, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 2163

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2026

| Patent document cited in search report | Publication date | Patent family member(s) | | Publication date |
|---|---|---|---|---|
| US 2005168290 A1 | 04-08-2005 | NONE | | |
| US 8952736 B1 | 10-02-2015 | NONE | | |
| US 2015381191 A1 | 31-12-2015 | CN | 105322959 A | 10-02-2016 |
| | | US | 2015381191 A1 | 31-12-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411534796